# EUROPEAN PATENT APPLICATION

(11) **EP 4 541 944 A1**
(43) Date of publication of application: **23.04.2025**
(21) Application number: 23306820.4
(22) Date of filing: 17.10.2023
(51) Int. Cl.: C25B 13/08, C25B 13/04, C25B 1/04

(54) **IMPROVED PROTON EXCHANGE MEMBRANE FOR WATER ELECTROLYSIS**

(71) Applicant: TOYOTA JIDOSHA KABUSHIKI KAISHA, Toyota-shi, Aichi-ken, 471-8571 (JP)
(72) Inventor: GUEGUEN, Aurélie, 1140 BRUSSELS (BE); COTTE, Stéphane, 1140 BRUSSELS (BE)
(74) Representative: Cabinet Beau de Loménie

(57) **Abstract**

A proton exchange membrane (10) for water electrolysis comprising a proton exchange substrate (12) coated on one side with a titanium oxide film (14), the titanium oxide film having a thickness (t₁₄) equal to or smaller than 100 nm. A method for making a proton exchange membrane for water electrolysis.

## Description

### BACKGROUND OF THE INVENTION

### 1. Field of the Invention

The invention relates to water electrolysis, and in particular to proton exchange membrane for water electrolysis.

### 2. Description of Related Art

Proton exchange membrane (PEM) are known for water electrolysis. However, crossover of O₂ from the cathode to the anode is detrimental to the proton exchange membrane. Indeed, permeation of O₂ through the proton exchange membrane may form H₂O₂ at the anode. Such H₂O₂ is detrimental to the proton exchange membrane as it may decompose in the presence of Fe²⁺ impurities into radicals that may attack the proton exchange membrane.

### SUMMARY OF THE INVENTION

The present disclosure relates to a proton exchange membrane for water electrolysis comprising a proton exchange substrate coated on one side with a titanium oxide (TiO₂) film, the film having a thickness equal to or smaller than 100 nm.

Thanks to the thickness of the titanium oxide film, the permeation of O₂ through the proton exchange membrane is reduced without impacting too strongly the proton conductivity of the proton exchange membrane.

In some embodiments, the proton exchange substrate may be a perfluorinated sulfonic acid membrane.

As non limiting examples, perfluorinated sulfonic acid membrane may be of the type commercialized under the reference Nafion^{™}.

In some embodiments, the thickness of the titanium oxide film may be equal to or smaller than 70 nm.

In some embodiments, the thickness of the titanium oxide film may be equal to or smaller than 20 nm.

The present disclosure also relates to a method for making a proton exchange membrane for water electrolysis, comprising the step of:
- providing a proton exchange substrate; and
- coating the proton exchange substrate on one side with a titanium oxide film, the titanium oxide film being deposited by spatial atomic layer deposition and having a thickness equal to or smaller than 100 nm.

This method may be carried out to obtain the proton exchange membrane described above. Spatial atomic layer deposition has the advantage of allowing for thinner film deposition on large samples and in a continuous manner, for example compared to atomic layer deposition. Therefore, costs of productions are reduced and productivity rate may be increased. Spatial atomic layer deposition also allows for deposition on one side of the substrate, therefore allowing deposition of the titanium oxide film on one side of the proton exchange substrate.

In some embodiments, precursors of the titanium oxide film may be water and tetrakis(dimethtylamino) titanium.

In some embodiments, the thickness of the titanium oxide film may be equal to or smaller than 70 nm.

In some embodiments, the thickness of the titanium oxide film may be equal to or smaller than 20 nm.

### BRIEF DESCRIPTION OF THE DRAWINGS

Features, advantages, and technical and industrial significance of exemplary embodiments of the invention will be described below with reference to the accompanying drawings, in which like signs denote like elements, and wherein:
FIG. 1 shows an exemplary proton exchange membrane for water electrolysis;
FIG. 2 shows a flow chart of a method for making proton exchange membrane for water electrolysis;
FIG. 3 shows the principle of spatial atomic layer deposition;
FIG. 4 shows a bright field TEM image of two areas of a first exemplary proton exchange membrane for water electrolysis;
FIG. 5 shows a HAADF-STEM image of two areas of the first exemplary proton exchange membrane for water electrolysis;
FIG. 6 shows a bright field TEM image of two areas of a second exemplary proton exchange membrane for water electrolysis;
FIG. 7 shows a HAADF-STEM image of two areas of the second exemplary proton exchange membrane for water electrolysis;
FIG. 8 shows the concentration (in at%) as a function of depth of the remove material (in nm SiO₂ equivalent) measured by XPS;
FIG. 9 shows the average conductivity (in mS/cm) as a function of the Relative Humidity (in %);
FIG. 10 shows the cell voltage (in V) as a function of the current density (in A.cm⁻²) before (solid line) and after (dotted line) activation.

### DETAILED DESCRIPTION OF EMBODIMENTS

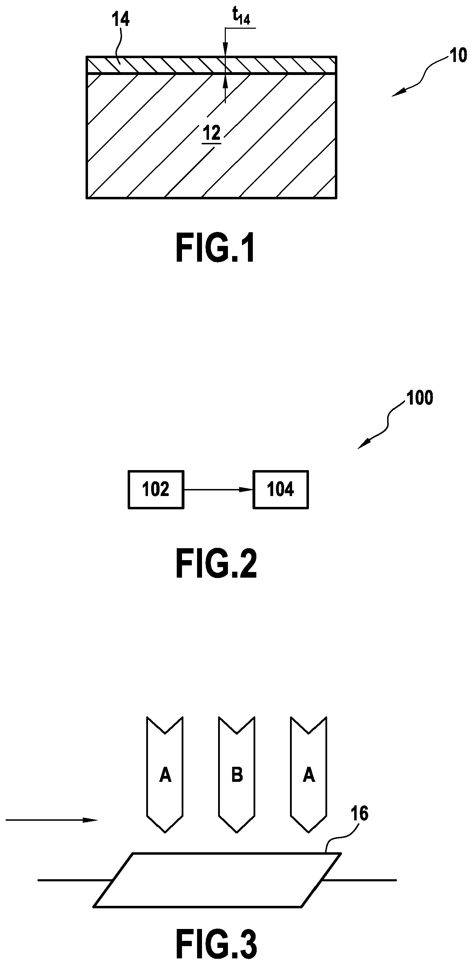

As shown in FIG. 1, a proton exchange membrane 10 for water electrolysis. The proton exchange membrane 10 includes a proton exchange substrate 12 and a film of titanium oxide 14 deposited onto the proton exchange substrate 12.

As a non-limiting example, the proton exchange substrate 12 may be made of Nafion^{™} 212.

FIG. 2 shows a flow chart of a method 100 for making a proton exchange membrane for water electrolysis.

The method 100 includes a step of providing 102 a proton exchange substrate 12.

As a non-limiting example, the proton exchange substrate 12 may be made of Nafion^{™} 212.

The method 100 includes a step of coating 104 the proton exchange substrate 12 on one side with a film of titanium oxide 14, the film being deposited by spatial atomic layer deposition and having a thickness t₁₄ equal to or smaller than 100 nm, for example equal to or smaller than 70 nm, for example equal to or smaller than 20 nm. The film of titanium oxide 14 may be directly in contact with the proton exchange substrate 12, e.g. directly in contact with the polymer forming the proton exchange substrate 12. As illustrated, only one side of the proton exchange substrate 12 may be covered with the film of titanium oxide 14.

FIG. 3 shows the principle of spatial atomic layer deposition, in which a substrate 16 to be coated pass under flux of gas A and B alternatively, so as to obtain the desired thickness.

As a non-limiting example, the gas A may be water and the gas B may be tetrakis(dimethtylamino) titanium.

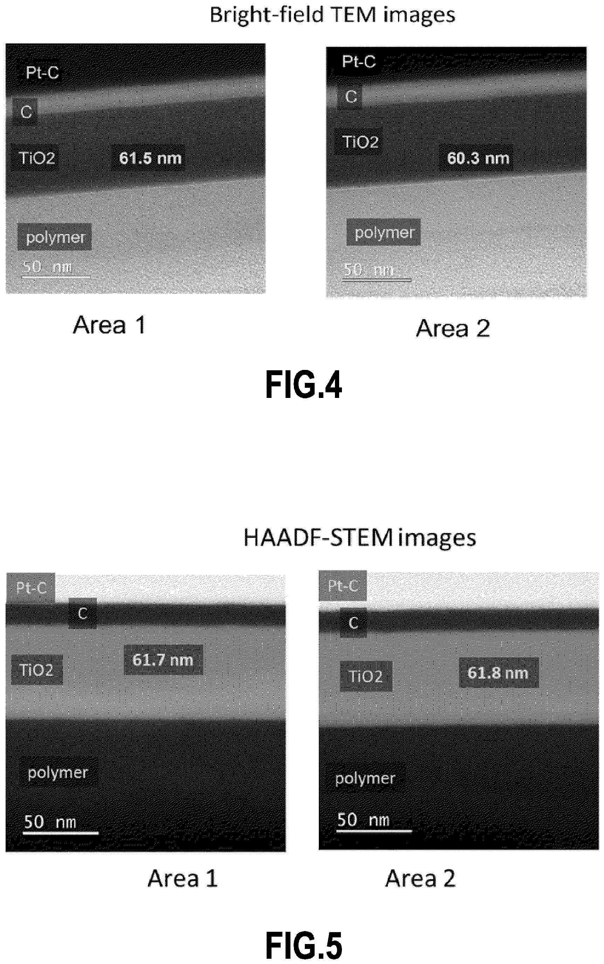

FIG. 4 shows a bright field TEM image of two areas of a first exemplary proton exchange membrane for water electrolysis. The first exemplary proton exchange membrane (Ex1) for water electrolysis has titanium oxide film having a thickness between 60.3 nm and 61.8 nm

FIG. 5 shows a HAADF-STEM image of two areas of the first exemplary proton exchange membrane for water electrolysis of FIG. 4. HAADF-STEM images allow for enhanced contrast, especially at lower atomic numbers, compared to TEM.

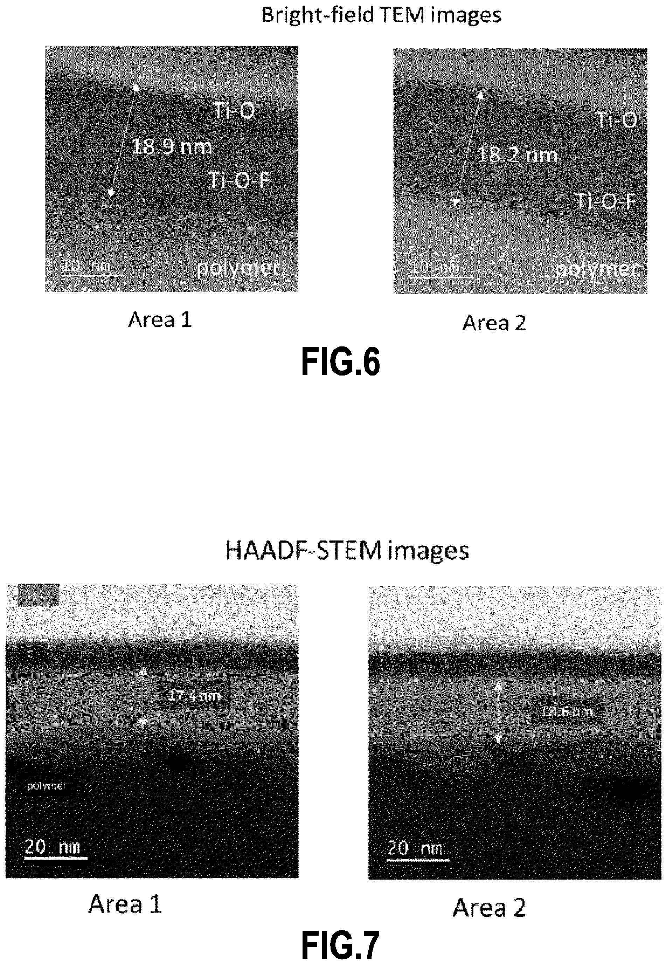

FIG. 6 shows a bright field TEM image of two areas of a second exemplary proton exchange membrane (Ex2) for water electrolysis. The second exemplary proton exchange membrane for water electrolysis has titanium oxide film having a thickness between 17.4 nm and 18.9 nm.

FIG. 7 shows a HAADF-STEM image of two areas of the second exemplary proton exchange membrane for water electrolysis of FIG. 6.

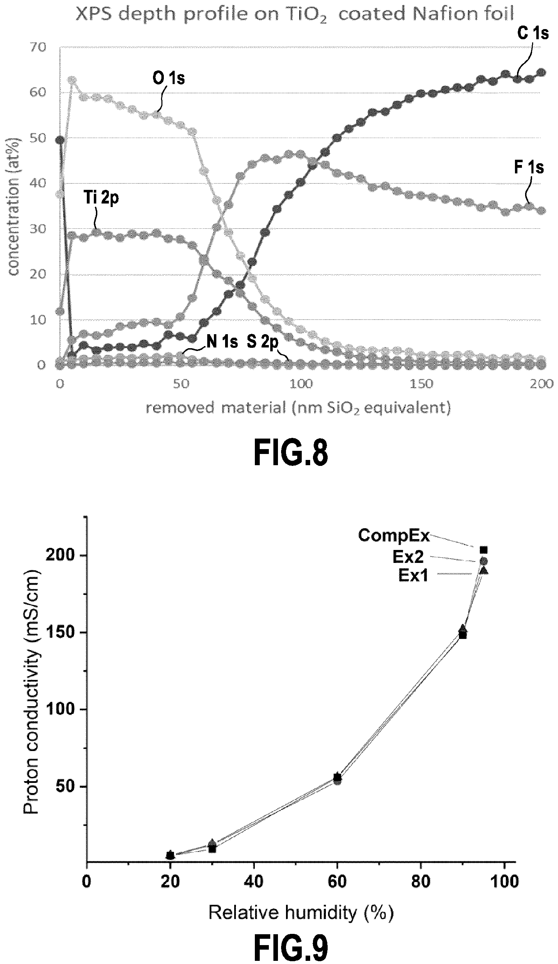

FIG. 8 shows the concentration (in at%) as a function of depth of the removed material (in nm SiO₂ equivalent) measured by XPS for the first exemplary proton exchange membrane showing the composition of the film is TiO₂. FIG. 8 is an in depth XPS profiling done by ion beam etching. In that case, the sputter rate was calibrated using SiO₂: sputter rate = 10 nm/min.

Table 1 shows hydrogen transmission rate (in cm³/(m².d.bar)) and oxygen transmission rate (g/(m².d)) through an uncoated Nafion 212 proton exchange membrane (CompEx), Ex1 and Ex2. Measurements of hydrogen transmission rate were carried out according to ISO 15105-1 at 23°C and 0% relative humidity and measurements of oxygen transmission rate were carried out according to ISO 15105-2 at 23°C and 50% relative humidity. Two samples were measured for CompEx, Ex1 and Ex2. For Ex1 and Ex2, the proton exchange membranes were disposed so that titanium oxide film was facing the gas.

**Table 1**

| Samples | Thickness (µm) | | | Hydrogen transmission rate | Oxygen transmission rate |
|---|---|---|---|---|---|
| | min | max | MW | | |
| CompEx | 47.6 | 49.3 | 48.4 | 11090 | 8670 |
| | 48.0 | 49.8 | 48.5 | 10770 | 8920 |
| Ex1 | 51.9 | 54.8 | 53.8 | 7620 | 6860 |
| | 52.8 | 55.2 | 54.0 | 7550 | 6950 |
| Ex 2 | 51.9 | 53.6 | 52.7 | 7220 | 8500 |
| | 48.1 | 49.4 | 48.7 | 8850 | 7080 |

FIG. 9 shows the average conductivity (in mS/cm) as a function of the Relative Humidity (in %) at 80°C for uncoated Nafion 212 proton exchange membrane, the first exemplary proton exchange membrane and the second exemplary proton exchange membrane. In particular, it is shown that there is no loss of conductivity for the second exemplary proton exchange membrane up to 95% relative humidity at 80°C. In this experiment, in plane proton conductivity was measured with four-probe method.

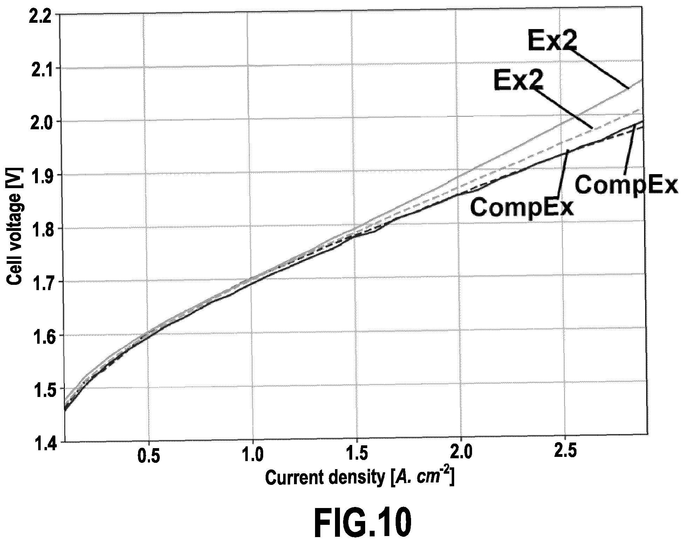

FIG. 10 shows the cell voltage (in V) as a function of the current density (in A.cm⁻²) at 80°C before (solid line) and after (dotted line) activation for a Membrane Electrode Assembly (MEA) comprising an uncoated proton exchange membrane (comparative example) and for a MEA comprising the second exemplary proton exchange membrane. A MEA was made by sandwiching the proton exchange membrane between two gas diffusion electrodes, one based on Ir catalyst (H₂O reduction) and one based Pt catalyst (H₂ oxidation). Performance electrochemical testing was done by galvanostatic intermittent titration technique (GITT).

Activation is carried out to study the effect of fast degradation of the proton exchange membrane. The activation was carried out applying 3 A/cm² current for 30 min.
MEA uncoated proton exchange membrane
Anode catalyst supplier: Umicore
PEM thickness: 50µm
PEM type: Nafion NR-212
Anode thickness wet: 60 µm
Anode Ir loading: 1.8634 mg.cm⁻²
Cathode thickness wet: 42 µm
Cathode Pt loading: 0.04101 mg.cm⁻²
Current density at 1.8V: 1.647 A.cm⁻²
MEA second exemplary proton exchange membrane
Anode catalyst supplier: Umicore
PEM thickness susbstrate: 50µm
PEM type: second exemplary proton exchange membrane
Anode thickness wet: 60 µm
Anode Ir loading: 1.8634 mg.cm⁻²
Cathode thickness wet: 42 µm
Cathode Pt loading: 0.04101 mg.cm⁻²
Current density at 1.8V: 1.64 A.cm⁻²

FIG. 10 shows that proton exchange membrane of the disclosure may be incorporated in MEA and tested in water electrolysis configuration.

The before activation polarization curve with the MEA with the second exemplary proton exchange membrane is similar to that of the MEA with uncoated proton exchange membrane, in particular up to 1.5 mA/cm². The same applies to the after activation polarization curve.

Although the present disclosure refers to specific exemplary embodiments, modifications may be provided to these examples without departing from the general scope of the invention as defined by the claims. In particular, individual characteristics of the different illustrated/mentioned embodiments may be combined in additional embodiments. Therefore, the description and the drawings should be considered in an illustrative rather than in a restrictive sense.

## Claims

1. A proton exchange membrane (10) for water electrolysis comprising a proton exchange substrate (12) coated on one side with a titanium oxide film (14), the titanium oxide film (14) having a thickness (t₁₄) equal to or smaller than 100 nm.

2. The proton exchange membrane (10) according to claim 1, wherein the proton exchange substrate (12) is a perfluorinated sulfonic acid membrane.

3. The proton exchange membrane (10) according to claim 1 or 2, wherein the thickness (t₁₄) of the titanium oxide film (14) is equal to or smaller than 70 nm.

4. The proton exchange membrane (10) according to claim 3, wherein the thickness (t₁₄) of the titanium oxide film (14) is equal to or smaller than 20 nm.

5. A method (100) for making a proton exchange membrane (10) for water electrolysis, comprising the step of:
- providing (102) a proton exchange substrate (12); and
- coating (104) the proton exchange substrate (12) on one side with a titanium oxide film (14), the titanium oxide film (14) being deposited by spatial atomic layer deposition and having a thickness (t₁₄) equal to or smaller than 100 nm.

6. The method (100) according to claim 5, wherein precursors of the titanium oxide film (14) are water and tetrakis(dimethtylamino) titanium.

7. The method (100) according to claim 5 or 6, wherein the thickness (t₁₄) of the titanium oxide film (14) is equal to or smaller than 70 nm.

8. The method (100) according to claim 7, wherein the thickness (t₁₄) of the titanium oxide film (14) is equal to or smaller than 20 nm.

## Amended claims

### Amended claims in accordance with Rule 137(2) EPC.

1. A method (100) for making a proton exchange membrane (10) for water electrolysis, comprising the step of:
- providing (102) a proton exchange substrate (12); and
- coating (104) the proton exchange substrate (12) on one side with a titanium oxide film (14), the titanium oxide film (14) being deposited by spatial atomic layer deposition and having a thickness (t₁₄) equal to or smaller than 100 nm, wherein precursors of the titanium oxide film (14) are water and tetrakis(dimethtylamino) titanium.

2. The method (100) according to claim 1, wherein the thickness (t₁₄) of the titanium oxide film (14) is equal to or smaller than 70 nm.

3. The method (100) according to claim 2, wherein the thickness (t₁₄) of the titanium oxide film (14) is equal to or smaller than 20 nm.
